# EUROPEAN PATENT APPLICATION

(11) **EP 4 721 923 A1**
(43) Date of publication of application: **08.04.2026**
(21) Application number: 24815611.9
(22) Date of filing: 31.05.2024
(51) Int. Cl.: B24D 11/00, B24B 37/00, B24B 37/12, B24B 57/02, B24D 3/28, H01L 21/304

(54) **POLISHING PAD AND METHOD FOR POLISHING OBJECT TO BE POLISHED**

(30) Priority: 02.06.2023 JP 2023091781; 02.06.2023 JP 2023091782; 24.07.2023 JP 2023119986
(71) Applicant: Kureha Corporation, Chuo-ku Tokyo 103-8552 (JP)
(72) Inventor: USHIRO, Kenta, Tokyo 103-8552 (JP); KUDO, Takahiro, Tokyo 103-8552 (JP)
(74) Representative: Hoefer & Partner Patentanwälte mbB
(86) International application number: PCT/JP2024/020034
(87) International publication number: WO 2024/248131

(57) **Abstract**

A polishing pad of the present invention includes a polishing layer including a composition containing a hydrolyzable resin and an abrasive grain having a median diameter of less than 2 µm.

## Description

### TECHNICAL FIELD

The present invention relates to a polishing pad and a method for polishing an object to be polished.

### BACKGROUND ART

In a processing process of a substrate to be used for a semiconductor device and the like, a cylindrical single crystal (ingot) is sliced into a disk shape to be formed into a wafer shape, and then rough polishing (lapping, primary polishing) is performed to adjust the thickness to a predetermined thickness while adjusting both surfaces of the wafer to be parallel to each other. The roughly polished wafer is further subjected to chemical etching and precision mechanical polishing (secondary polishing, mechanical polishing) for forming a mirror surface having high flatness. Finally, finish polishing (chemical mechanical polishing, CMP) in which a chemical action is also added is performed in order to obtain atomic-level planarization.

In the precision mechanical polishing of such a semiconductor substrate processing process, a polishing method using a fixed abrasive polishing pad including a polishing layer containing a binder resin and abrasive grains fixed by the binder resin is known. As the above-described binder resin, a curable resin such as a phenol resin, an epoxy resin, or an acrylic phenol resin is usually used (see, for example, Patent Document 1).

### CITATION LIST

### PATENT DOCUMENT

Patent Document 1: JP 2018-051733 A

### SUMMARY OF INVENTION

### TECHNICAL PROBLEM

In general precision mechanical polishing, polishing is performed using a hard metal platen while supplying a slurry containing abrasive grains. Thus, the surface layer of the substrate is likely to have minute cracks and scratches, and a damaged layer is likely to be formed.

In particular, unlike a silicon (Si) substrate, a substrate of silicon carbide (SiC), gallium nitride (GaN), or the like used for a next-generation power semiconductor device not only has high hardness but also is chemically stable. Thus, when the damaged layer is formed by precision mechanical polishing, the damaged layer cannot be easily removed by a chemical method such as chemical etching, and it is necessary to perform finish polishing for a long time, which increases processing cost of a wafer.

On the other hand, since the polishing pad using the binder resin as described above is softer and has a lower elastic modulus than the polishing pad using metal and/or ceramic, it is expected that precision mechanical polishing can be performed with less damage even on a highly brittle substrate such as a SiC substrate. In order to reduce damage due to the precision mechanical polishing, it is desirable to use fine abrasive grains having a small abrasive grain size as much as possible. In the precision mechanical polishing, fine abrasive grains having a median diameter of 3 µm or less are generally often used. However, according to the study of the present inventors, there is a problem that the polishing speed is significantly reduced when the fine abrasive grains are fixed with the binder resin as described above.

Therefore, in the fixed abrasive grain polishing pad using fine abrasive grains, it is desired that the damaged layer can be reduced while reducing a decrease in polishing speed, and preferably, the decrease in polishing speed is small even without performing dressing (exposing the sharp parts of new abrasive grains), and the damaged layer can be removed.

The present invention has been made in view of the above-described circumstances, and an object of the present invention is to provide a polishing pad that can reduce a damaged layer while reducing a decrease in polishing speed, and a method for polishing an object to be polished using the polishing pad.

### SOLUTION TO PROBLEM

[1] A polishing pad, including a polishing layer containing a hydrolyzable resin and an abrasive grain having a median diameter (D50) of less than 2 µm.
[2] The polishing pad according to [1], wherein the hydrolyzable resin contains a glycolic acid polymer as a main component.
[3] The polishing pad according to [1] or [2], wherein a content of the abrasive grain is 55 mass% or less with respect to a total mass of the polishing layer.
[4] A method for polishing an object to be polished, the method including polishing the object to be polished by sliding the polishing pad and the object to be polished relative to each other while supplying, to a surface of the polishing layer of the polishing pad according to any one of [1] to [3], a polishing liquid containing water.
[5] The method for polishing an object to be polished according to [4], wherein the object to be polished contains silicon carbide or gallium nitride.
[6] The method for polishing an object to be polished according to [4] or [5], wherein the polishing liquid is an alkaline aqueous solution.

### ADVANTAGEOUS EFFECTS OF INVENTION

According to the present invention, it is possible to provide a polishing pad that can reduce a damaged layer while reducing a decrease in polishing speed and a method for polishing an object to be polished using the polishing pad.

### BRIEF DESCRIPTION OF THE DRAWINGS

FIG. 1A is a schematic plan view of a polishing pad according to an embodiment of the present invention, and FIG. 1B is a schematic cross-sectional view taken along line 1B-1B of the polishing pad of FIG. 1A.
FIG. 2 is a schematic cross-sectional view illustrating a method for polishing an object to be polished according to an embodiment of the present invention.
FIGS. 3A to 3C are schematic cross-sectional views illustrating a method of manufacturing a polishing pad in Examples.

### DESCRIPTION OF EMBODIMENTS

The reason why a polishing speed remarkably decreases when fine abrasive grains are fixed with a known binder resin is considered as follows. In the fine abrasive grains, a protrusion height of the abrasive grain and a chip pocket (gap between an object to be polished and the binder resin, which has a role of discharging scraps) are also small, and therefore, when even a small amount of scraps are generated, clogging easily occurs. Since the binder resin described above does not have hydrolyzability, there is no dressing effect, and renewal by fresh grains is less likely to occur. From these, it is considered that the polishing speed is significantly reduced.

The present inventors have studied various binder resins for fixing the abrasive grains in a polishing pad, and have found that a resin having hydrolyzability such as a glycolic acid polymer exhibits the dressing effect, whereby clogging hardly occurs even when fine abrasive grains are used. As a result, it has been found that a decrease in polishing speed can be reduced without performing a dressing treatment even in the case of using fine abrasive grains, which has been difficult with known resins. Then, the present inventors have also studied the size of the abrasive grains, have found that a damaged layer can be significantly reduced by setting a median diameter to less than 2 µm, and have arrived at the present invention.

That is, the polishing pad according to an embodiment of the present invention includes a polishing layer containing a hydrolyzable resin and abrasive grains having a median diameter of less than 2 µm. Hereinafter, the configuration of the polishing pad will be described in detail.

### 1. Polishing pad

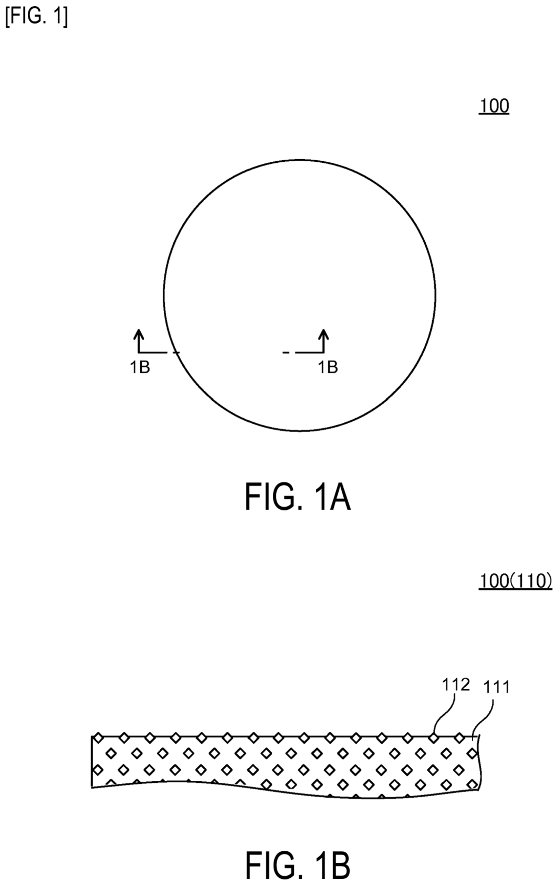

FIG. 1A is a schematic plan view of a polishing pad 100 according to an embodiment of the present invention, and FIG. 1B is a schematic cross-sectional view taken along line 1B-1B of the polishing pad 100 of FIG. 1A.

The polishing pad 100 according to the present embodiment includes a polishing layer 110 (see FIG. 1B).

### 1-1. Polishing layer

In the present embodiment, the polishing layer 110 contains a composition containing a matrix resin 111 containing a hydrolyzable resin and abrasive grains 112 fixed by the matrix resin 111 (see FIG. 1B).

### 1-1-1. Hydrolyzable resin

The hydrolyzable resin is not particularly limited as long as it is a resin exhibiting hydrolyzability. The hydrolyzable resin may be a biodegradable resin or may not be the biodegradable resin.

Examples of the hydrolyzable resin include polyester having an ester bond in the main chain, and polycarbonate having a carbonate bond in the main chain. Examples of the hydrolyzable resin include a lactic acid polymer, a glycolic acid polymer, a hydroxybutyric acid polymer, a hydroxyvaleric acid polymer, a caprolactone polymer, an ethylene succinate polymer, a butylene succinate polymer (examples thereof include polybutylene succinate, polybutylene succinate adipate, polybutylene succinate terephthalate, polyethylene succinate, and polybutylene succinate carbonate), a dioxanone polymer, and a trimethylene carbonate polymer. Among them, a lactic acid polymer and a glycolic acid polymer are preferable, and a glycolic acid polymer is preferable from the viewpoint of having higher strength and hydrolysis rate and more easily adjusting the protrusion height of the abrasive grains of the polishing layer. That is, the hydrolyzable resin preferably contains the glycolic acid polymer as a main component. Containing the glycolic acid polymer as a main component means that the content of the glycolic acid polymer is 50 mass% or more, preferably 70 mass% or more, more preferably 80 mass% or more, still more preferably 90 mass% or more, and particularly preferably 95 mass% or more with respect to a total amount of the hydrolyzable resin.

The glycolic acid polymer is a polymer containing a structural unit (-(-O-CH₂-CO-)-) derived from glycolic acid, and is a polymer containing the structural unit derived from glycolic acid as a main component. The glycolic acid polymer may be a homopolymer of glycolic acid or a copolymer of glycolic acid and a monomer copolymerizable therewith.

Examples of copolymerizable monomers include glycols such as ethylene glycol, propylene glycol, butanediol, heptanediol, hexanediol, octanediol, nonanediol, decanediol, 1,4-cyclohexane dimethanol, neopentyl glycol, bisphenol A, polyethylene glycol, polypropylene glycol, and polytetramethylene glycol; dicarboxylic acids such as oxalic acid, adipic acid, sebacic acid, azelaic acid, dodecanedioic acid, malonic acid, glutaric acid, cyclohexane dicarboxylic acid, terephthalic acid, isophthalic acid, phthalic acid, naphthalene dicarboxylic acid, bis(p-carboxyphenyl)methane, anthracene dicarboxylic acid, 4,4'-diphenyl ether dicarboxylic acid, 5-sodium sulfoisophthalic acid, and 5-tetrabutyl phosphonium isophthalic acid; hydroxycarboxylic acids such as lactic acid, hydroxypropionic acid, hydroxybutyric acid, hydroxyvaleric acid, hydroxycaproic acid, and hydroxybenzoic acid; lactides; lactones such as caprolactone, valerolactone, propiolactone, undecalactone, and 1,5-oxepan-2-one; and carbonates such as trimethylene carbonate.

Containing the structural unit derived from glycolic acid as a main component means that a content ratio of the structural unit derived from glycolic acid is 50 mass% or more with respect to a total amount of structural units included in the glycolic acid polymer. The content of the structural unit derived from glycolic acid is preferably 70 mass% or more, more preferably 80 mass% or more, still more preferably 90 mass% or more, and particularly preferably 95 mass% or more. When the content ratio of the structural unit included in the glycolic acid polymer is 50 mass% or more, the strength of the glycolic acid polymer can be further maintained, so that more sufficient strength can be obtained when used for a polishing pad. In addition, when the content ratio of the structural unit included in the glycolic acid polymer is 70 mass% or more, hydrolysis more easily proceeds, so that the decrease in polishing speed can be further reduced.

Among them, the glycolic acid polymer is preferably a homopolymer of glycolic acid from the viewpoint of higher strength and ease of hydrolysis.

A weight average molecular weight of the glycolic acid polymer is not particularly limited, and is preferably 70000 or more and 500000 or less. When the weight average molecular weight of the glycolic acid polymer is 70000 or more, the strength of the glycolic acid polymer can be further enhanced, and thus the retentivity and durability of the abrasive grains can be further enhanced. In addition, it is possible to obtain more sufficient strength for handling such as when removing the polishing pad from a mold at the time of molding or when attaching the polishing pad to a platen of a polishing apparatus. Furthermore, it is possible to make it difficult for the abrasive grains protruding from the surface to be pushed back to the matrix resin when a load is applied by bringing the polishing pad into contact with the object to be polished. As a result, even if fine abrasive grains are used, the polishing speed can be made more difficult to decrease. When the weight average molecular weight of the glycolic acid polymer is 500000 or less, not only moldability can be further maintained, but also a time until degradation by hydrolysis can be further shortened. From the same viewpoint, the weight average molecular weight of the glycolic acid polymer is more preferably 110000 or more and 400000 or less.

The weight average molecular weight of the glycolic acid polymer can be measured by gel permeation chromatography (GPC). The measurement conditions can be as follows.

### Measurement conditions

Device: "Shodex-104", available from Showa Denko K.K.
Columns: two HFIP-606M and, as a precolumn, one HFIP-G were connected in series
Column temperature: 40°C
Eluent: HFIP solution in which 5 mM sodium trifluoroacetate is dissolved
Flow rate: 0.6 mL/min
Detector: RI (differential refractive index) detector
Molecular weight calibration: five types of standard polymethylmethacrylates having different molecular weights

The content of the hydrolyzable resin is preferably 20 mass% or more and 99 mass% or less, more preferably 30 mass% or more and 95 mass% or less, still more preferably 50 mass% or more and 90 mass% or less, and particularly preferably 70 mass% or more and 90 mass% or less with respect to the polishing layer (or the total amount of the composition). When the content of the hydrolyzable resin is 20 mass% or more, the strength of the polishing layer containing abrasive grains is further increased, which is preferable. When the content of the hydrolyzable resin is 99 mass% or less, a proportion of the abrasive grains is not too small, and the polishing speed is not too low, which is preferable. When the content of the hydrolyzable resin is as described above, it is easy to obtain a more stable polishing speed by the dressing effect while suppressing excessive degradation of the polishing layer.

### 1-1-2. Abrasive grain

In the present embodiment, as described above, abrasive grains having a median diameter of less than 2 µm are used. When the median diameter of the abrasive grains is less than 2 µm, even for a highly brittle object to be polished such as a SiC substrate, it is easy to perform ductile processing, and the damaged layer can be effectively reduced. The lower limit value of the median diameter of the abrasive grains is not particularly limited, and is preferably 0.01 µm or more from the viewpoint of adjusting to the protrusion height of the abrasive grains suitable for polishing and further increasing the polishing speed. From the same viewpoint, the median diameter of the abrasive grains is preferably 0.01 µm or more and less than 2 µm, more preferably 0.05 µm or more and 1 µm or less, still more preferably 0.1 µm or more and 0.5 µm or less, and particularly preferably 0.2 µm or more and 0.3 µm or less.

The median diameter of the abrasive grains can be determined from a particle size distribution measured in accordance with a particle diameter analysis-laser diffraction/scattering method (ISO 13320:2020).
Specifically, measurement can be performed using a laser diffraction particle size analyzer (for example, Mastersizer 3000 available from Malvern Instruments) under conditions of a measurement temperature of 21°C, an ion-exchanged water as a dispersion medium, a dispersion medium refractive index of 1.330, and Mie theory as a light scattering model.

The material of the abrasive grains is not particularly limited, and examples thereof include diamond, silicon carbide, boron carbide, boron nitride, silicon nitride, cerium oxide, aluminum oxide, zirconium oxide, silicon oxide, iron oxide, manganese oxide, magnesium oxide, calcium oxide, barium oxide, zinc oxide, titanium oxide, chromium oxide, barium carbonate, and calcium carbonate. Among them, diamond, boron carbide, and boron nitride are preferable from the viewpoint of further increasing the polishing speed, and diamond is more preferable from the viewpoint of facilitating processing of a substrate having high hardness such as a SiC substrate.

The shape of the abrasive grains is not particularly limited, and may be spherical, polyhedral, or amorphous. The abrasive grains may be subjected to a surface treatment for imparting crushability, or may be subjected to a coating for enhancing a holding force of the hydrolyzable resin.

The content of the abrasive grains is not particularly limited, and is preferably 1.0 mass% or more and 80 mass% or less with respect to the polishing layer (or the total amount of the composition). When the content of the abrasive grains is 80 mass% or less, when a load is applied by bringing the polishing pad into contact with the object to be polished, the load is not excessively dispersed, a suitable load is applied to each abrasive grain, and the abrasive grains are easily cut into the object to be polished. As a result, even if fine abrasive grains are used, the polishing speed can be further increased. In addition, the moldability or processability to the polishing pad can be further enhanced. From the same viewpoint, the content of the abrasive grains is more preferably 5.0 mass% or more and 70 mass% or less, still more preferably 10 mass% or more and 50 mass% or less, and particularly preferably 10 mass% or more and 30 mass% or less with respect to the polishing layer (or the total amount of the composition).

The content of the abrasive grains can be measured by a thermogravimetric analysis (TGA) apparatus.
Specifically, on a surface of the polishing layer of the unused polishing pad, when an arbitrary straight line passing through a center O of the polishing layer is defined as a straight line L, and a straight line passing through the center O of the polishing layer perpendicularly to the straight line L is defined as a straight line M, and when the center O of the polishing layer and a middle point between the center O of the polishing layer and an end of the polishing layer on the straight line L are defined as a1 and a2, and a middle point between the center O of the polishing layer and an end of the polishing layer on the straight line M is defined as b1 and b2, 100 mg or more of measurement samples are collected from the polishing layer from a range including measurement points of O, a1, a2, b1, and b2, and appropriately pulverized to obtain measurement samples from the respective measurement points. 20 mg± 2 of the measurement sample was placed in a platinum pan, and the temperature was raised from room temperature to 800°C at a rate of 10°C/min in an air atmosphere, and held at 800°C for 30 minutes, components other than the abrasive grains were burned and removed, and the remaining sample weight was divided by the mass of the measurement sample to determine the content of the abrasive grains in the polishing layer at each measurement point. In the present application, an arithmetic average value of the abrasive grain content of each of the five points was defined as a representative value of the content of the abrasive grains of the polishing layer.

### 1-1-3. Other components

The matrix resin containing the hydrolyzable resin may include only the hydrolyzable resin, or may further contain other components other than the hydrolyzable resin. Examples of other components include resins other than the hydrolyzable resin, and hydrolysis accelerators. Among them, from the viewpoint of further increasing the polishing speed, the polishing layer preferably further contains a hydrolysis accelerator. One type of hydrolysis accelerators may be used alone, or two or more types of hydrolysis accelerators may be used in combination.

The hydrolysis accelerator is a compound that accelerates a hydrolysis reaction of the hydrolyzable resin, and is preferably, for example, a compound that accelerates the penetration of a solution into the hydrolyzable resin by being eluted in a polishing liquid, and is more preferably a compound that generates an acid or an alkali in the presence of water. Examples of such degradation accelerators include carboxylic anhydrides, phosphorus compounds, cyclic esters, and basic metal oxides.

Examples of the carboxylic acid anhydride include hexanoic anhydride, octanoic anhydride, decanoic anhydride, lauric anhydride, myristic anhydride, palmitic anhydride, stearic anhydride, benzoic anhydride, succinic anhydride, maleic anhydride, phthalic anhydride, trimellitic acid anhydride, tetrahydrophthalic anhydride, butanetetracarboxylic dianhydride, benzophenone-3,3',4,4'-tetracarboxylic dianhydride, diphenylsulfone tetracarboxylic dianhydride, biphenyltetracarboxylic dianhydride, ethyleneglycol bisanhydrotrimellitate, and glycerin bis anhydrotrimellitate monoacetate. Among them, phthalic anhydride, trimellitic acid anhydride, benzoic anhydride, benzophenone-3,3',4,4'-tetracarboxylic dianhydride, and benzene-1,2,4,5-tetracarboxylic anhydride (pyromellitic anhydride) are preferable.

The phosphorus compound is preferably an organic phosphorus compound such as a phosphoric acid ester and a phosphite ester, and more preferably an organic phosphorus compound having at least one selected from the group consisting of a long-chain alkyl group having from 8 to 24 carbons, an aromatic ring, and a pentaerythritol skeleton.

Examples of the phosphoric acid ester having a long-chain alkyl group having from 8 to 24 carbons include mono- or di-stearyl acid phosphate or their mixture, and di-2-ethylhexyl acid phosphate.
Examples of the phosphite ester having an aromatic ring include tris(nonylphenyl) phosphite.
Examples of the phosphite ester having a pentaerythritol skeleton include cyclic neopentanetetraylbis(2,6-di-tert-butyl-4-methylphenyl)phosphite, cyclic neopentanetetraylbis(2,4-di-tert-butylphenyl)phosphite, and cyclic neopentanetetraylbis(octadecyl)phosphite.

Examples of cyclic esters include glycolide, lactide, ε-caprolactone, γ-valerolactone, δ-valerolactone, diglycolic anhydride, and glutaric anhydride.

Examples of basic metal oxides include magnesium oxide, zinc oxide, calcium oxide, sodium oxide, and copper oxide.

Among them, a cyclic ester is preferable, and glycolide is more preferable from the viewpoint of relatively stably existing at the time of molding and further promoting the hydrolysis of the hydrolyzable resin such as the glycolic acid polymer in the polishing layer in which water has permeated.

The content of the hydrolysis accelerator is preferably 0.5 mass% or more and 50 mass% or less with respect to the total amount of the hydrolyzable resin. When the content of the hydrolysis accelerator is 0.5 mass% or more, the hydrolysis of the hydrolyzable resin can be further promoted, and the decrease in the polishing speed can be further reduced. When the content of the hydrolysis accelerator is 50 mass% or less, not only bleeding out of the hydrolysis accelerator can be made more difficult to occur, but also excessive collapse due to excessive progress of hydrolysis can be further suppressed. From the same viewpoint, the content of the hydrolysis accelerator is more preferably 1 mass% or more and 30 mass% or less, and still more preferably 10 mass% or more and 20 mass% or less.

### 1-1-4. Physical properties

As described above, it is preferable that the hydrolysis rate and the strength of the matrix resin containing the hydrolyzable resin are moderately high from the viewpoint of making it difficult to further decrease the polishing speed even when fine abrasive grains are used.

### Thickness reduction rate

The hydrolysis rate of the matrix resin can be represented by, for example, a thickness reduction rate. The thickness reduction rate when a molded article of the matrix resin is immersed in 60°C water is preferably 12 µm/h or more. The polishing layer containing the matrix resin having such a thickness reduction rate is easily hydrolyzed by supplying the polishing liquid, and the dressing effect is more easily obtained. The upper limit value of the thickness reduction rate is not particularly limited, and is preferably 2 mm/h or less, more preferably 1 mm/h or less, still more preferably 500 µm/h or less, and particularly preferably 100 µm/h or less from the viewpoint of extending the life of the polishing pad.

The thickness reduction rate can be measured by the following procedure.
1) The composition containing no abrasive grains is injection-molded to obtain a square column of 10 mm × 10 mm × 120 mm, and a cubic test piece (molded article) having a side of 10 mm is obtained from the square column. The molded article of the composition not containing the abrasive grains can also be obtained by heating and melting the molded article of the composition containing the abrasive grains, that is, the polishing layer. The polishing layer is heated and melted, the resulting melt is passed through a filter, and separated into a composition containing abrasive grains and a hydrolyzable resin other than the abrasive grains, that is, a composition not containing the abrasive grains, and the composition not containing the abrasive grains is molded to prepare a molded article, which can be used as a test piece.
2) Next, the test piece is placed in a 1 L autoclave, the autoclave is filled with 60°C water (deionized water), the test piece is completely immersed at ambient pressure, and the operation is repeated to prepare immersion test pieces with different immersion times.
   Each immersion test piece is cut to expose a cross-section. After drying, a thickness of a core portion (hard portion) of the test piece is measured. A reduced thickness is measured from a difference from a thickness before immersion (10 mm).
3) The change of the reduced thickness of the test piece over time is determined based on the measured value of the reduced thickness of the test piece measured for different immersion time periods. Then, the thickness reduction rate (unit: mm/h) of the test piece having a thickness of 10 mm is calculated from the time variation for the reduced thickness of the test piece in a range where the reduced thickness of the test piece has linear variation over time.

The thickness reduction rate of the matrix resin can be adjusted by, for example, the type and content of hydrolyzable resin, and the type and content of the hydrolysis accelerator. For example, when the hydrolyzable resin contains a glycolic acid polymer, the thickness reduction rate tends to increase. When the content of the hydrolysis accelerator is high, the thickness reduction rate tends to increase.

### Tensile Strength

A tensile strength at 25°C of the matrix resin is preferably 55 MPa or more. When the tensile strength is 55 MPa or more, a retention force of the abrasive grains can be further increased. From the same viewpoint, the tensile strength of the matrix resin is more preferably 60 MPa or more. The upper limit of the tensile strength of the matrix resin is not particularly limited, and can be, for example, 1000 MPa or less. The tensile strength can be measured according to ISO527.

### Tensile modulus of elasticity

A tensile modulus of elasticity at 25°C of the matrix resin is preferably 1 GPa or more. When the tensile modulus of elasticity is 1 GPa or more, it is possible to make it difficult for the abrasive grains protruding from the surface to be pushed back to the matrix resin when a load is applied by bringing the polishing pad into contact with the object to be polished. As a result, even if fine abrasive grains are used, the decrease in the polishing speed can be further reduced. In addition, it is possible to reduce edge roll-off (a phenomenon in which an edge portion is intensively scraped and dimensional precision is lowered) of the object to be polished after polishing. From the same viewpoint, the tensile modulus of elasticity of the matrix resin is more preferably 3 GPa or more, and still more preferably 5 GPa or more. The upper limit of the tensile modulus of elasticity of the matrix resin is not particularly limited, and can be, for example, 50 GPa or less. The tensile modulus of elasticity can be measured according to ISO527.

The tensile strength and the tensile modulus of elasticity of the matrix resin can be adjusted by the type and content of the hydrolyzable resin, the type and content of the hydrolysis accelerator, the weight average molecular weight, a cooling step at the time of molding, and the like. For example, when the content of the hydrolysis accelerator is low, the tensile strength and the tensile modulus of elasticity tend to increase.

### Thickness

The thickness of the polishing layer is not particularly limited, and, for example, when the polishing layer is used for processing a substrate of a semiconductor device, the thickness is preferably 0.01 mm or more and 50 mm or less, more preferably 0.1 mm or more and 30 mm or less, still more preferably 0.3 mm or more and 10 mm or less, and particularly preferably 0.5 mm or more and 5 mm or less. When the thickness of the polishing layer is 0.01 mm or more, it is preferable from the viewpoint that the polishing layer can sufficiently hold the abrasive grains.

### 1-2. Other layers

As described above, the polishing pad 100 may further include other layers as necessary. Examples of other layers include a substrate layer and an adhesive layer. The substrate layer can be, for example, a resin film. The adhesive layer can be an adhesive layer for attaching the polishing pad 100 to a polishing platen (platen 210 described later).

### 2. Method of manufacturing polishing pad

The polishing pad according to the present embodiment can be manufactured by any method. For example, a polishing pad can be manufactured through the steps of: 1) obtaining a composition containing a hydrolyzable resin and abrasive grains; and 2) molding the obtained composition.

### Step of 1)

The composition can be obtained by any method. For example, the composition can be obtained by kneading a hydrolyzable resin and abrasive grains. As a kneader, for example, a roll, a kneader, a Banbury mixer, an extruder (uniaxial or multiaxial extruder), or the like can be used.

The kneading is preferably performed under heating from the viewpoint of enhancing processability. The heating temperature can be, for example, 150°C or higher and 270°C or lower. In particular, when the composition contains a hydrolysis accelerator, the heating temperature is preferably a temperature at which the hydrolysis accelerator can be dispersed in a stable state.

The form of the composition to be obtained is not particularly limited, and may be, for example, a pellet form, a powder form, or a filament form.

### Step of 2)

Next, the obtained composition is formed into a predetermined shape. The molding method is not particularly limited, and may be, for example, any of an injection molding method, a melt extrusion molding method, a solidification- and extrusion-molding method, a vacuum molding method, a transfer molding method, and a compression molding method. Furthermore, molding by a 3D printer may be performed.

When a molded article is produced by a compression molding method, pellets of the composition are supplied into a mold. Then, the mold temperature is set to 150°C or higher and 270°C or lower, and press molding is performed to obtain a polishing pad containing a molded article.

As described later, a groove may be formed on the surface of the polishing layer obtained by forming. The method for forming a groove is not particularly limited, and the groove may be formed by cutting the surface of the molded article of the composition, or the groove may be formed by molding the composition using a mold or template in which a pattern corresponding to the groove is formed. Annealing may be performed as necessary from the viewpoint of enhancing dimensional stability of the molded product.

### 3. Method for polishing object to be polished

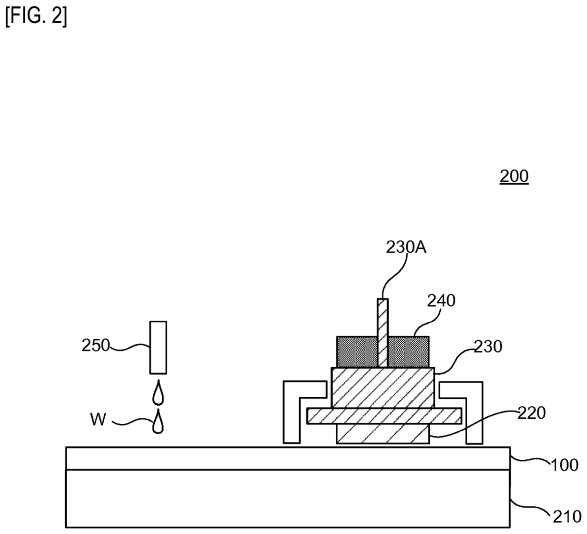

FIG. 2 is a schematic view illustrating a polishing apparatus 200 using the polishing pad 100 according to the present embodiment. In the drawing, the detailed illustration of the polishing pad 100 is omitted.

As illustrated in FIG. 2, the polishing apparatus 200 includes the polishing pad 100, the disk-shaped platen 210 that supports the polishing pad 100, a disk-shaped polishing head 230 that holds an object to be polished 220, a weight 240, and a supply nozzle 250 that supplies a polishing liquid W. The platen 210 is rotatable by a rotation shaft (not illustrated), and the polishing head 230 is rotatable by a rotation shaft 230A.

In the present embodiment, the polishing pad 100 and the object to be polished 220 are slid relative to each other while the polishing liquid W containing water is supplied to a surface of the polishing pad 100, thereby polishing the object to be polished 220.

Specifically, first, the polishing pad 100 is attached to the platen 210. Next, the object to be polished 220 held by the polishing head 230 is pressed against a polishing surface of the polishing pad 100, and the platen 210 and/or the polishing head 230 are rotated while the polishing liquid W is supplied from the supply nozzle 250. As a result, the polishing pad 100 and the object to be polished 220 are slid relative to each other to polish a processing surface (surface to be polished) of the object to be polished 220.

The material of the object to be polished 220 is not particularly limited, and may be a ceramic material, a glass material, or the like. Examples of the ceramic material include Si (silicon), SiC (silicon carbide), GaN (silicon nitride), GaAs (gallium arsenide), and sapphire, and SiC and GaN are preferable. Specifically, examples of the object to be polished 220 include materials for semiconductor devices, electronic components, and the like, particularly Si substrates, SiC substrates, GaAs substrates, glass, and substrates for hard disks and LCDs (liquid crystal displays). Among them, a semiconductor wafer is preferable, a SiC substrate, a sapphire substrate, or a GaN substrate used for a power device is more preferable, and a SiC substrate or a GaN substrate is still more preferable.

The polishing liquid W contains at least water. When the polishing pad 100 contains the glycolic acid polymer as the hydrolyzable resin, from the viewpoint of promoting the hydrolysis of the glycolic acid polymer and further enhancing the dressing effect, the polishing liquid W is preferably an alkaline or acidic aqueous solution, and more preferably an alkaline aqueous solution. In an alkaline aqueous solution, a carboxylic acid terminal generated by hydrolysis remains as a carboxylate ion, and an oligomer of a polymer generated by hydrolysis is easily eluted into a liquid. Thus, an alkaline aqueous solution can further promote hydrolysis as compared with an acidic aqueous solution.

The alkaline aqueous solution contains water and an alkaline substance. Examples of the alkaline substance include alkali metal hydroxides such as sodium hydroxide (NaOH) and potassium hydroxide (KOH), and organic alkalis such as tetramethylammonium = hydroxide. The pH of the alkaline aqueous solution is preferably 9 or more, more preferably 12 or more, and still more preferably 13 or more from the viewpoint of further promoting the hydrolysis of the glycolic acid polymer. The upper limit value of the pH can be, for example, 14. The pH is a value measured by a pH meter at 20°C. The pH of the alkaline aqueous solution can be adjusted by the amount of the alkaline substance.

The temperature of the polishing liquid W is not particularly limited, and may be 1°C or higher and 60°C or lower.

The polishing liquid W may further contain other components than the ones described above, for example, a hydrolysis accelerator.

### 4. Modified example

In the above-described embodiment, the surface of the polishing layer is flat; however, the present invention is not limited thereto, and the groove may be disposed. As a result, a polishing liquid can be easily spread over the entire surface of the polishing layer through the groove, and scraps generated by hydrolysis of the hydrolyzable resin can be easily discharged to the outside through the groove.

The groove may be disposed so as to be able to supply or discharge the polishing liquid and discharge the scraps of the hydrolyzable resin generated by hydrolysis. A plan view shape of the groove may be an annular shape, a radial shape, or a lattice shape, or may be a linear shape. Protrusions of an uneven pattern formed by the groove may be arranged in an island shape.

In the above-described embodiment, the polishing pad includes only the polishing layer; however, the present invention is not limited thereto, and another layer may be further included. When the polishing pad further includes a substrate layer, the polishing layer may be uniformly disposed on the substrate layer or may be disposed in a pattern.

In the above-described embodiment, the median diameter of the abrasive grains is set to less than 2 µm from the viewpoint of making it difficult to highly form the damaged layer; however, the present invention is not limited thereto. For example, when it is only necessary to make the depth of the damaged layer thinner than a known case, the median diameter of the abrasive grains may be 3 µm or less, for example, 0.01 µm or more and 3 µm or less.

### EXAMPLES

Hereinafter, the present disclosure will be described with reference to Examples. The scope of the present disclosure is not to be construed as being limited by Examples.

### 1. Material

### 1-1. Binder resin

· PGA (glycolic acid homopolymer, weight average molecular weight: 298000, thickness reduction rate: 12.3 µm/h, tensile strength: 112.8 MPa)

The weight average molecular weight, the thickness reduction rate, and the tensile strength of the PGA were measured by the following methods.

### Measurement of weight average molecular weight

The weight average molecular weight was measured by gel permeation chromatography (GPC). The measurement conditions were as follows.
Device: Shodex-104, available from Showa Denko K.K.
Columns: two HFIP-606M and, as a precolumn, one HFIP-G were connected in series
Column temperature: 40°C
Eluent: HFIP solution in which 5 mM sodium trifluoroacetate is dissolved
Flow rate: 0.6 mL/min
Detector: RI (differential refractive index) detector
Molecular weight calibration: five types of standard polymethylmethacrylates having different molecular weights

### Measurement of thickness decrease rate

The PGA was injection-molded to obtain a square column of 10 mm × 10 mm × 120 mm, and then a cubic test piece (molded article) having a side of 10 mm was obtained from the square column.

The resulting test piece was placed in a 1 L autoclave. Then, the autoclave was filled with water (deionized water) at a temperature of 60°C, and the test piece was completely immersed at ambient pressure to perform an immersion test.

The test piece after immersion was taken out at predetermined time intervals to prepare test pieces with different immersion times, and each test piece was cut to expose a cross section. After the test piece was left to stand overnight in a dry room and dried, the thickness of the core part (hard portion) of the test piece was measured. The reduced thickness was measured from the difference between the thickness before immersion (initial thickness, specifically 10 mm) and after immersion. The change of the reduced thickness of the test piece over time was determined based on the measured value of the reduced thickness of the test piece measured for different immersion time periods. Then, the thickness reduction rate (unit: mm/h) of the test piece having a thickness of 10 mm was calculated from the time variation for the thickness reduction of the test piece in a range where the thickness reduction of the test piece had linear variation over time.

### Measurement of tensile strength

The tensile strength of the PGA was measured according to ISO527.

### 1-2. Abrasive grain

Abrasive grain 1: polycrystalline diamond powder (available from Kemet International Ltd, median diameter: 0.25 µm, irregular shape)
Abrasive grain 2: polycrystalline diamond powder (available from Kemet International Ltd, median diameter: 3.0 µm, irregular shape)

### Method for measuring median diameter

The median diameter of the abrasive grains was measured by the following method.

That is, using a laser diffraction particle size analyzer Mastersizer 3000 (Malvern), the measurement was performed by setting conditions of a measurement temperature of 21°C, an ion-exchanged water as a dispersion medium, a dispersion medium refractive index of 1.330, Mie theory as a light scattering model, a particle absorption index of 0.100 of polycrystalline diamond powder, and a particle refractive index of 2.418. An amount of the abrasive grains added to the dispersion medium was adjusted so that laser scattering intensity was 4% or more and 10% or less.

### 2. Preparation and evaluation of polishing pad

### Tests 1 to 3

### (1) Preparation of polishing pad

### Kneading step

The PGA as the binder resin and the abrasive grains presented in Table 1 were weighed so as to have an amount ratio presented in Table 1, and kneaded using Labo Plastomill (available from Toyo Seiki Seisaku-sho, Ltd.) to obtain a composition. The kneading was performed at a predetermined heater temperature for a preheating time of 1 minute, a kneading time of 5 minutes, and a rotation speed of 50 rpm. The heater temperature was set to 250°C, and the kneading was performed.

### Molding step

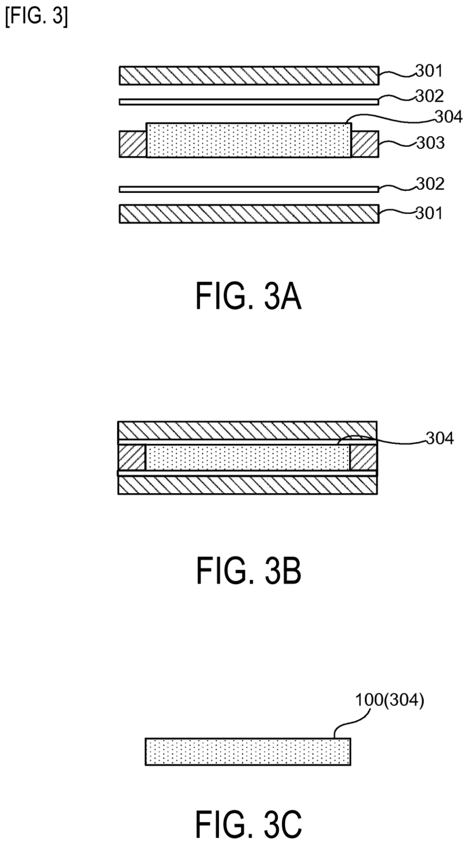

FIG. 3 is a schematic view illustrating a member of a molding apparatus 300 used in Examples. In the drawing, reference numeral 301 denotes a ferro plate, and reference numeral 302 denotes an aluminum foil.

An SUS mold 303 having a hole with a diameter of 150 mm and a thickness of 0.5 mm was disposed as illustrated in FIG. 3, a composition 304 kneaded as described above was set in the SUS mold 303, and press-molded to obtain the polishing pad 100 including a polishing layer having a thickness of 0.5 mm as illustrated in FIG. 1. The temperature of a pressing machine was set to the same temperature as the heater temperature of the Labo Plastomill.

### (2) Evaluation

### Pretreatment of polishing pad

Since the abrasive grains of the polishing pad immediately after molding were buried in the resin, a polishing test was performed after dressing with a grinding wheel of #800.

### Pre-processing of object to be polished

A surface of a SiC substrate of 20 × 20 mm square as the object to be polished was roughly polished with a copper platen using a slurry containing polycrystalline diamond having a median diameter of 1 µm, and lapping was performed.

### Polishing test

As illustrated in FIG. 2, the polishing test was performed by attaching the polishing pad to the polishing apparatus 200. Specifically, the polishing pad was attached to the platen 210 (polishing platen) using a double-sided adhesive film (for example, AS ONE OCA50-A4). A double-sided adhesive sheet was bonded to the polishing pad and the polishing platen using a rubber roller or the like so that air bubbles did not enter during the bonding.

Next, the SiC substrate (20 × 20 mm square) subjected to the pre-processing as the object to be polished 220 was pressed against the rotating polishing pad to perform polishing processing. The polishing conditions were as follows. At this time, loads of the jig (polishing head 230) and the weight 240 are applied to the substrate.

### Polishing conditions

Polishing apparatus: Dialap ML-150P (available from MARUTO INSTRUMENT CO., LTD.)
Rotational speed of polishing platen: 100 rpm
Polishing platen diameter: diameter 150 mm
Forced driving and swinging of object to be polished: none
Surface pressure: 250 gf/cm²
Flow rate of polishing liquid: 75 mL/h
Polishing liquid: NaOH aqueous solution (20°C) with pH = 13

Then, the polishing speed, the surface roughness of the object to be polished, and the depth of the damaged layer were measured by the following methods.

### (1) Polishing speed

The thickness of the object to be polished was measured by an electric micrometer Millimar1240 (available from Mahr GmbH) in a state where the object to be polished was attached to a jig.

The thickness of the object to be polished was measured at five points, and an average value thereof was taken. The polishing speed was obtained by calculation from the polishing time (min) and a thickness decrease value (removal amount, µm).

### (2) Surface roughness of object to be polished

An arithmetic mean height Sa (µm) of the surface of the SiC substrate as the object to be polished after being polished for 2 hours was measured using a laser microscope VK-X260 (available from KEYENCE CORPORATION) and taken as surface roughness. The measurement was performed using an objective lens of 20 times and N.A. = 0.46.

The arithmetic mean height Sa (µm) of the surface of the polished SiC substrate was measured using an atomic force microscope (AFM) (scanning probe microscope SPI-3800/SPA-300HV, available from Seiko Instruments Inc.) under conditions of a cantilever: SI-AF01, a scanning area: 5000 nm × 5000 nm, a scanning frequency: 1.00 Hz, an atmosphere: atmosphere, a temperature: room temperature (21°C), and a bias voltage: 0 V.

### (3) Depth of damaged layer

Using a transmission electron microscope (TEM), a cross section of the SiC substrate after polishing for 2 hours was observed, and the depth of the damaged layer was estimated from the obtained TEM image. Specifically, measurement was performed by the following procedure.

### Cross-sectional TEM sample

A cross-sectional TEM sample was microsampled using a focused ion beam apparatus to be thinned and prepared. Sampling was performed for a streak formed near a center of the polishing surface, taking a cross section orthogonal to the streak.

### TEM observation

As a TEM apparatus, a JEM-2100 F-type field emission transmission electron microscope available from JEOL Ltd. was used. An acceleration voltage was 200 kV. The depth of the damaged layer was determined by reading a maximum depth from a scale bar in an observation image.

### Test 4

For comparison, the SiC substrate was polished using a tin platen (high polishing platen available from MARUTO INSTRUMENT CO., LTD.) used in a process of precision polishing. In the polishing using the tin platen, a slurry (available from MARUTO INSTRUMENT CO., LTD.) containing the abrasive grains 1 (polycrystalline diamond having a median diameter of 0.25 µm) was used as the polishing liquid.

### Polishing conditions

Polishing apparatus: Dialap ML-150P (available from MARUTO INSTRUMENT CO., LTD., tin platen)
Rotational speed of polishing platen: 100 rpm
Polishing platen diameter: diameter 150 mm
Forced driving and swinging of object to be polished: none
Surface pressure: 250 gf/cm²
Flow rate of slurry: 50 g/h
Then, in the same manner as described above, the polishing speed, the surface roughness of the object to be polished, and the depth of the damaged layer were measured by the following methods.

The configuration and evaluation results of the polishing pads of Tests 1 to 4 are presented in Table 1.

**[Table 1]**

| | | | Test 1 | Test 2 | Test 3 | Test 4 |
|---|---|---|---|---|---|---|
| Configuration | Polishing tool | | PGA polishing pad | PGA polishing pad | PGA polishing pad | Tin platen |
| | Polishing method | | Fixed abrasive grain | Fixed abrasive grain | Fixed abrasive grain | Free abrasive grain |
| | Binder resin | Content/mass% (/vol.%^{*}) | 90 (95.3) | 90 (95.3) | 70 (84.1) | - |
| | Abrasive grain | Type | Abrasive grain 1 | Abrasive grain 2 | Abrasive grain 1 | - |
| | | Median diameter (µm) | 0.25 | 3 | 0.25 | - |
| | | Content/mass% (/vol.%^{*}) | 10 (4.7) | 10 (4.7) | 30 (15.9) | - |
| | Polishing liquid | | pH13 NaOHaq. | pH13 NaOHaq. | pH13 NaOHaq. | - |
| | Polishing slurry | | - | - | - | Abrasive grain 1 (median diameter 0.25 µm) |
| Evaluation | Polishing speed/(µm/h) | | 0.97 | 11.5 | 0.10 | Unmeasurable |
| | Surface roughness | Laser/nm | 2.5 | 8.1 | 2.4 | 2.8 |
| | | AFM/nm | 0.111 | 2.12 | 0.153 | 0.278 |
| | Depth of damaged layer/nm | | 10 | | | 120 |

| | | | | | | |
|---|---|---|---|---|---|---|
| * vol.% based on total volume of polishing layer | | | | | | |

As presented in Table 1, in Test 4, it is found that the depth of the damaged layer is as large as 120 nm even though polycrystalline diamond slurry having an average particle size of 0.25 µm is used. On the other hand, in Test 1, it is found that the depth of the damaged layer can be reduced to 10 nm while suppressing the decrease in polishing speed.

Further, it is found that the surface roughness of the SiC substrate can be further reduced by further reducing the median diameter of the abrasive grains (comparison between Tests 1 and 2). Furthermore, it is found that the polishing speed is further increased by decreasing the amount of the abrasive grains (comparison between Tests 1 and 3).

The present application claims priority based on Japanese Patent Application No. 2023-91781 and Japanese Patent Application No. 2023-091782, both of which are filed on June 2, 2023, and Japanese Patent Application No. 2023-119986 filed on July 24, 2023. The contents described in the specifications and drawings of the priority application are incorporated by reference in its entirety to the specification of the present application.

### INDUSTRIAL APPLICABILITY

According to the present invention, it is possible to provide the polishing pad that can reduce the damaged layer while suppressing the decrease in polishing speed and the method for polishing the object to be polished using the polishing pad.

### REFERENCE SIGNS LIST

100 Polishing pad
110 Polishing layer
111 Matrix resin
112 Abrasive grain
200 Polishing apparatus
210 Platen
220 Object to be polished
230 Polishing head
230A: Rotation shaft
240 Weight
250 Supply nozzle
301 Ferro plate
302 Aluminum foil
303 SUS mold
304 Composition

## Claims

1. A polishing pad, comprising a polishing layer comprising a composition containing a hydrolyzable resin and an abrasive grain having a median diameter of less than 2 µm.

2. The polishing pad according to claim 1, wherein the hydrolyzable resin contains a glycolic acid polymer as a main component.

3. The polishing pad according to claim 1 or 2, wherein a content of the abrasive grain is 55 mass% or less with respect to a total mass of the polishing layer.

4. A method for polishing an object to be polished, the method comprising polishing the object to be polished by sliding the polishing pad and the object to be polished relative to each other while supplying, to a surface of the polishing layer of the polishing pad described in any one of claims 1 to 3, a polishing liquid containing water.

5. The method for polishing an object to be polished according to claim 4, wherein the object to be polished contains silicon carbide or gallium nitride.

6. The method for polishing an object to be polished according to claim 4 or 5, wherein the polishing liquid is an alkaline aqueous solution.
